# EUROPEAN PATENT APPLICATION

(11) **EP 2 333 952 A2**
(43) Date of publication of application: **15.06.2011**
(21) Application number: 10192566.7
(22) Date of filing: 25.11.2010
(51) Int. Cl.: H03G 3/30

(54) **Method for controlling audio output and digital device using the same**

(30) Priority: 30.11.2009 KR 20090117060
(71) Applicant: SAMSUNG ELECTRONICS CO., LTD., Suwon-si Gyeonggi-do 442-742 (KR)
(72) Inventor: Han, Jae-hee, Gyeonggi-do (KR)
(74) Representative: Land, Addick Adrianus Gosling

(57) **Abstract**

A method for controlling an audio output and a digital device using the same are provided. The digital device adjusts an output level of an audio signal to a first level if it is determined that an audio output device, which is connected to an audio output terminal of the digital device, is of a first type, and adjusts the output level of the audio signal to a second level if it is determined that the audio output device is of a second type. Therefore, an audio signal is transferred to various types of audio output devices through a single audio output terminal, thereby adjusting the output level of the audio signal to a proper level according to the type of the audio output device and transferring the audio signal having the properly adjusted level.

## Description

This application claims priority from Korean Patent Application No. 10-2009-0117060, filed on November 30, 2009, in the Korean Intellectual Property Office, the disclosure of which is incorporated herein by reference in its entirety.

Apparatuses and methods consistent with the exemplary embodiments relate to controlling an audio output of a digital device, and more particularly, to a method for outputting audio capable of being output through a built-in speaker through an external audio output device, and a digital device using the same.

A digital television (DTV) which is representative of a digital device includes a speaker mounted therein, through which audio may be output. Moreover, a DTV may transfer an audio signal to an audio output device connected through an audio output terminal, and thus enables an audio to be output through the connected audio output device.

Many kinds of audio output devices have been developed such that the number of audio output terminals included on a DTV have been increased.

However, if the number of audio output terminals on the DTV is increased, a user may face the difficulty when using the DTV since it may be difficult for a user to know which audio output terminal an audio output device has to be connected to.

Exemplary embodiments may address at least the above problems and/or disadvantages and other disadvantages not described above. Also, an exemplary embodiment is not required to overcome the disadvantages described above, and an exemplary embodiment may not overcome any of the problems described above.

One or more exemplary embodiments provide a method which enables a user to connect an external audio output device more easily. To this end, one or more exemplary embodiments provide a method for controlling an audio output so that an output level of an audio signal is adjusted to a proper level according to the type of an audio output device when various types of audio output devices are connected through a single audio output terminal, and a digital device using the same.

According to an aspect of an exemplary embodiment, there is provided a digital device including, a video processor which performs signal processing on a video signal; a display which displays the video signal processed by the video processor; an audio processor which performs signal processing on an audio signal, wherein the audio output device is separate from the digital device; an audio output terminal to which an audio output device is connected, and which transfers the audio signal processed by the audio processor to the audio output device connected to the audio output terminal; and a controller which determines a type of the audio output device connected to the audio output terminal, controls the audio processor to adjust an output level of the audio signal to a first level if the controller determines that the audio output device is a first type of audio output device, and controls the audio processor to adjust the output level of the audio signal to a second level if the controller determines that the audio output device is a second type of audio output device.

The second level may be equal to or less than the first level. The second level may be proportional to a currently set volume level of the audio signal. The first level may be a maximum output level of the audio signal.

The first type of audio output device may be an audio output device having a first output power, and the second type of audio output device may be an audio output device having a second output power which is lower than the first output power.

The controller may determine the type of the audio output device connected to the audio output terminal based on an input made on a graphical user interface (GUI) displayed on the display.

The controller may control the GUI to be displayed on the display if the controller determines that the audio output device is connected to the audio output terminal.

The digital device may further include an internal speaker which is connected to the audio processor and which outputs the audio signal processed by the audio processor; and a switching unit which causes the audio signal processed by the audio processor to be output to either the internal speaker or the audio output terminal, wherein the controller controls the switching unit so that the audio signal processed by the audio processor is output to the audio output terminal if the controller determines that the audio output device is connected to the audio output terminal.

The controller may control the switching unit so that the audio signal processed by the audio processor is output to the internal speaker if it is determined that the audio output device is not connected to the audio output terminal.

The first type of audio output device and the second type of external audio output device may be configured to be connected to a same audio output terminal.

The digital device may further include a broadcast reception unit which receives a broadcast signal from an external source, wherein the video signal and the audio signal are separated from the broadcast signal.

The digital device may further include a broadcast separation unit which separates the broadcast signal received from the broadcast reception unit into the video signal and the audio signal, and outputs the separated signals to the video processor and the audio processor, respectively.

According to an aspect of another exemplary embodiment, there is provided a method for controlling an audio output, the method including performing signal processing on a video signal; displaying the processed video signal on a display; determining a type of an audio output device which is connected to an audio output terminal of the digital device and is separate from the digital device; adjusting an output level of the audio signal to a first level if it is determined that the audio output device is a first type of audio output device; adjusting the output level of the audio signal to a second level if it is determined that the audio output device is a second type of audio output device; and transferring the audio signal of which the output level is adjusted to the audio output device connected to the audio output terminal.

The second level may be equal to or less than the first level. The second level may be proportional to a currently set volume level of the audio signal. The first level may be a maximum output level of the audio signal.

The first type of audio output device may be an audio output device having a first output power, and the second type of audio output device may be an audio output device having a second output power which is lower than the first output power.

The determining may include determining the type of the audio output device connected to the audio output terminal based on an input made on a graphical user interface (GUI) displayed on the display.

The method may further include displaying the GUI on the display, if it is determined that the audio output device is connected to the audio output terminal.

The first type of audio output device and the second type of audio output device are connected to a same audio output terminal.

The method may further include receiving a broadcast signal from an external source, wherein the video signal and the audio signal are separated from the broadcast signal.

### BRIEF DESCRIPTION OF THE DRAWINGS

The above and/or other aspects of the exemplary embodiments will be more apparent by describing the exemplary embodiments with reference to the accompanying drawings, in which:

FIG. 1 is a block diagram illustrating a digital television (DTV) according to an exemplary embodiment;

FIG. 2 is a detailed block diagram illustrating an audio output unit of FIG. 1;

FIG. 3 is a flowchart provided to explain a method for controlling an audio output according to an exemplary embodiment; and

FIG. 4 is a view illustrating a graphical user interface (GUI) for selecting an audio output device according to an exemplary embodiment.

### DETAILED DESCRIPTION OF THE EXEMPLARY EMBODIMENTS

Certain exemplary embodiments will now be described in greater detail with reference to the accompanying drawings.

In the following description, the like drawing reference numerals are used for like elements throughout the drawings. The matters defined in the description, such as the detailed construction and elements, are provided to assist in a comprehensive understanding of the exemplary embodiments. Thus, it is apparent that the exemplary embodiments can be carried out without those specifically defined matters. Also, well-known functions or constructions are not described in detail since they would obscure the exemplary embodiments with unnecessary detail.

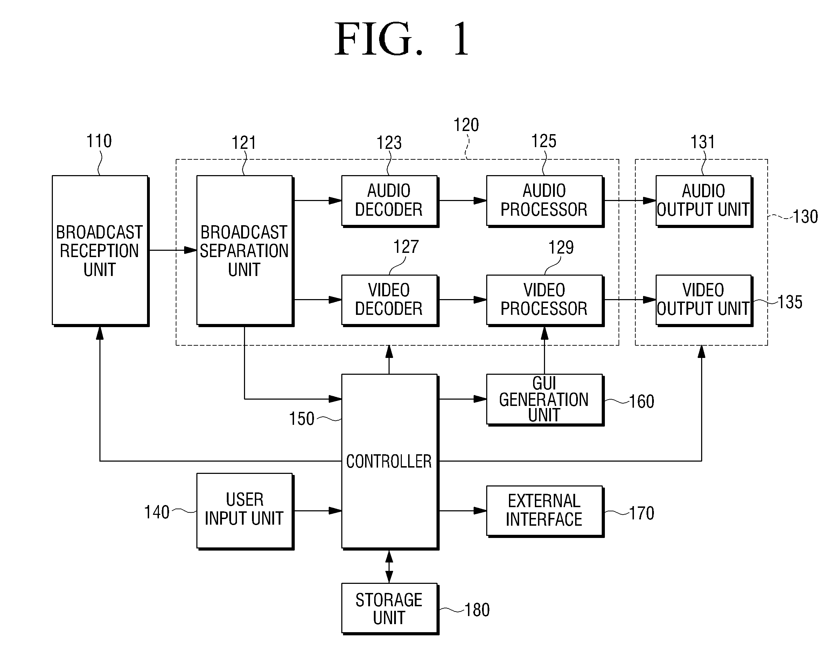

FIG. 1 is a block diagram illustrating a digital television (DTV) according to an exemplary embodiment. Referring to FIG. 1, the DTV comprises a broadcast reception unit 110, an audio video (A/V) processor 120, an A/V output unit 130, a user input unit 140, a controller 150, a graphical user interface (GUI) generation unit 160, an external interface 170, and a storage unit 180.

The broadcast reception unit 110 tunes to one of various broadcast signals which are received over wire or wirelessly, and demodulates the tuned broadcast signal.

The A/V processor 120 processes a broadcast signal output from the broadcast reception unit 110. The A/V processor 120 which performs the above operation comprises a broadcast separation unit 121, an audio decoder 123, an audio processor 125, a video decoder 127, and a video processor 129.

The broadcast separation unit 121 separates the broadcast signal output from the broadcast reception unit 110 into an audio signal, a video signal, and additional data, and outputs the separated signals and data. The audio signal and the video signal separated from the broadcast signal are input to the audio decoder 123 and the video decoder 127, respectively. The additional data separated from the broadcast signal is input to the controller 150.

The audio decoder 123 decodes an audio signal output from the broadcast separation unit 121. Accordingly, the audio decoder 123 outputs a decompressed audio signal.

The audio processor 125 performs audio signal processing on the decoded audio signal output from the audio decoder 123, and transfers the processed audio signal to the audio output unit 131 of the A/V output unit 130. The audio signal processing may include adjusting an audio output level (e.g., a volume level). The operation of adjusting an audio output level is performed according to the control of the controller 150 (to be described below).

The video decoder 127 decodes a video signal output from the broadcast separation unit 121. Accordingly, the video decoder 127 outputs a decompressed video signal.

The video processor 129 processes a decoded video signal output from the video decoder 127, and transfers the processed video signal to the video output unit 135 of the A/V output unit 130. The video signal processing may include color signal processing, scaling, and frame rate conversion (FRC), and so on.

The GUI generation unit 160 generates a GUI to be displayed on a display under the control of the controller 150. The GUI generation unit 160 generates a GUI through which a user may input information and commands via a user input unit 140.

The GUI generated by the GUI generation unit 160 is input to the video processing unit 129, and is added to a video to be displayed on a display.

The output unit 130 outputs a video and an audio corresponding to a video signal and an audio signal output from the A/V processor 120, and provides a user with the video and audio. The output unit 130, which performs the above operation, comprises the audio output unit 131 and the video output unit 135.

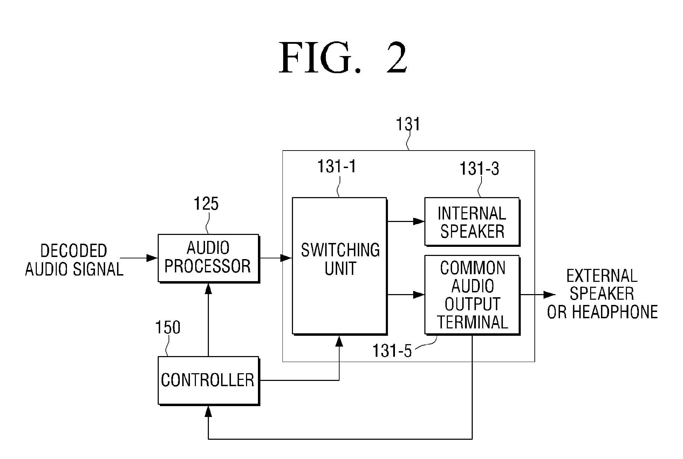

The audio output unit 131 outputs an audio signal output from the audio processor 125 through a built-in speaker or through an external audio output device connected via a cable. The manner in which the audio output unit 131 outputs an audio may be controlled by the controller 150 which will be explained later. The detailed description of the audio output unit 131 will be explained later with reference to FIG. 2.

The video output unit 135 outputs a video signal output from the video processor 129 through a display.

The external interface 170 is communicably linked to an external device (e.g., a universal serial bus (USB) memory, a digital camera, etc.) and an external network (e.g., Internet, local area network (LAN), etc.). Contents which are received from the external device or the external network through the external interface 170 may also be processed by the A/V processor 120 and then output through the A/V output unit 130.

The storage unit 180 provides a storage space in which contents are stored. The contents stored in the storage unit 180 may also be processed by the A/V processor 120 and then output through the A/V output unit 130. Examples of storage unit 180 include magnetic media such as hard disks, floppy disks, and magnetic tape; optical media such as Compact Disc read-only-media (CD ROM) disks and Digital Versatile Disc (DVD); magnetooptical media such as optical disks; flash memory devices; and other hardware memory devices.

The user input unit 140 transfers a command that a user inputs using manipulation buttons provided on a remote controller or a front panel of the DTV to the controller 150.

The controller 150 includes at least one processor and controls overall operations of the DTV according to a command received from the user input unit 140. In more detail, the controller 150 controls the broadcast reception unit 110, the external interface 170, the storage unit 180, the A/V processor 120, and the A/V output unit 130 so that a broadcasting program and contents selected by a user are provided through the DTV and/or other external output devices.

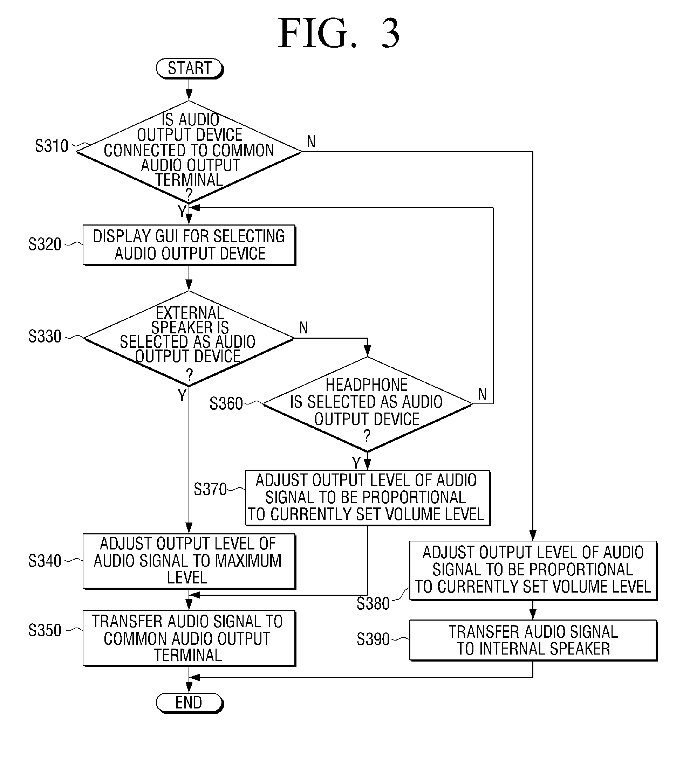

The controller 150 controls an audio output manner of the audio output unit 131. Hereinbelow, the audio output unit 131 will be explained with reference to FIG. 2, and then the process that the controller 150 performs to control an audio output of the audio output unit 131 will be explained in detail with reference to FIG. 3.

FIG. 2 is a detailed block diagram illustrating the audio output unit 131 of FIG. 1. FIG. 2 further illustrates the audio processor 125, which is provided on a fore end of the audio output unit 131, the controller 150, which controls the audio processor 125 and the audio output unit 131, in addition to the audio output unit 131 for better understanding and convenience of description.

Referring to FIG. 2, the audio output unit 131 comprises a switching unit 131-1, an internal speaker 131-3, and a common audio output terminal 131-5.

The switching unit 131-1 switches between the internal speaker 131-3 and the common audio output terminal 131-5 so that an audio signal output from the audio processor 125 is output to either the internal speaker 131-3 or to the common audio output terminal 131-5.

The internal speaker 131-3, which is incorporated in the DTV, outputs an audio signal transferred from the audio processor 125 through the switching unit 131-1.

An external audio output device (not shown), such as an external speaker, a headphone, or another type of audio output device, may be selectively connected to the common audio output terminal 131-5 which is configured to receive a connector of various types of external audio output devices. As the common audio output terminal 131-5 is for common use, the external speaker and the headphone may be connected to the same audio output terminal.

The common audio output terminal 131-5 outputs an audio signal which is transferred from the audio processor 125 through the switching unit 131-1 to an external audio output device which is connected to the common audio output terminal 131-5.

As shown in control lines of FIG. 2, the controller 150 controls the operation of the audio processor 125 and the operation of the switching unit 131-1, and refers to a signal input from the common audio output terminal 131-5 to do so.

Hereinbelow, the process that the controller 150 performs to control the audio processor 125 and the switching unit 131-1 will be explained in detail with reference to FIG. 3. FIG. 3 is a flowchart provided to explain a method for controlling an audio output according to an exemplary embodiment.

Referring to FIG. 3, the controller 150 determines whether an external audio output device is connected to the common audio output terminal 131-5 (5310) which is configured to receive a connector of various types of external audio output devices.

One of the ports provided on the controller 150 is connected to the common audio output terminal 131-5. If an external audio output device is connected to the common audio output terminal 131-5, the port of the controller is designed to be connected to ground. That is, the common audio output terminal 131-5 is configured to output a signal corresponding to ground, if an external audio output device is connected to the common audio output terminal 131-5. Therefore, if the port of the controller receives a signal corresponding to ground, the controller 150 determines that an external audio output device is connected to the common audio output terminal 131-5. The audio output terminal 131-5 may be configured to output the signal to the controller 150 continuously, and automatically adjusts the signal based on whether an external audio output device is connected to the common audio output terminal 131-5. Accordingly, the controller 150 may automatically determine whether an external audio output device is connected to the common audio output terminal 131-5 by monitoring the signal.

If it is determined that an external audio output device is connected to the common audio output terminal 131-5 (S310-Y), the controller 150 controls the GUI generation unit 160 to display a GUI for selecting an external audio output device (5320).

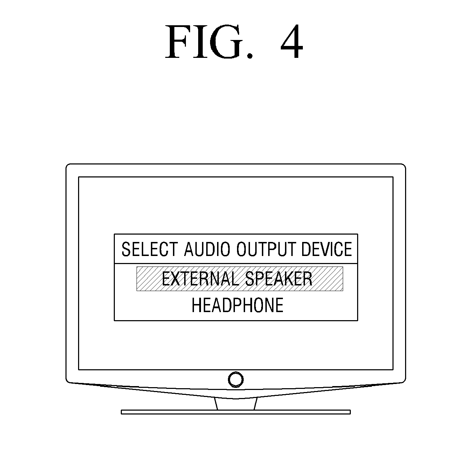

FIG. 4 illustrates a GUI for selecting an audio output device according to an exemplary embodiment. The GUI for selecting an external audio output device illustrated in FIG. 4 is a GUI which is used to input the type of external audio output device connected to the common audio output terminal 131-5.

For example, a user selects one of the external speaker and the headphone listed in the GUI of FIG. 4 using the user input unit 140, and manually inputs the type of the external audio output device.

Specifically, if the external speaker is connected to the common audio output terminal 131-5, a user may select the external speaker on the GUI for selecting an external audio output device. On the other hand, if the headphone is connected to the common audio output terminal 131-5, a user may select the headphone on the GUI for selecting an audio output device.

If the external speaker is selected on the GUI while selecting an external audio output device as the external audio output device (5330-Y), the controller 150 controls the audio processor 125 to adjust an output level of an audio signal to the maximum level (S340). The external speaker adjusts the output level of the audio signal to the maximum level in operation S340 since the audio signal having a high output level is appropriate to be output. Accordingly, the controller 150 may store preset output levels which correspond to an output level appropriate for the type of external audio output device. In this exemplary embodiment, the controller stores a preset maximum output level corresponding to the external speaker because an audio signal having a high (i.e., maximum) output level is appropriate to be output by the external speaker.

It is to be understood the external speaker is provided with volume control means or is connected to the common audio output terminal through an amplifier or similar device having a volume control device so that the output volume of the speaker can be adjusted.

The controller 150 controls the switching unit 131-1 so that the audio signal which the audio processor 125 has adjusted to the maximum level is transferred to the common audio output terminal 131-5 (S350).

Therefore, the audio signal having the maximum output level is transferred to the external speaker which is connected to the common audio output terminal 131-5, and thus the external speaker outputs an audio using the audio signal.

Alternatively, if the headphone is selected on the GUI for selecting an external audio output device (S360-Y), the controller 150 controls the audio processor 125 so that an output level of the audio signal is adjusted to be proportional to the currently set volume level (S370).

Since the output level of an audio signal is proportional to the currently set volume level, 1) if the currently set volume level is high, the output level of an audio signal is set to be high by the audio processor 125, and 2) if the currently set volume level is low, the output level of an audio signal is set to be low by the audio processor 125.

Accordingly, damage to the hearing of a user from sound output too loudly through the headphone can be prevented.

The controller 150 controls the switching unit 131-1 to transfer the audio signal output from the audio processor 125 to the common audio output terminal 131-5 (S350).

Therefore, the audio signal having an output level proportional to the currently set volume level is transferred to the headphone connected to the common audio output terminal 131-5, and the headphone outputs an audio using the audio signal.

If an external audio output device is not connected to the common audio output terminal 131-5 (5310-N), the controller 150 detects a signal which does not correspond to ground at its port. In this case, the controller 150 controls the audio processor 125 so that the output level of an audio signal is adjusted to be proportional to the currently set volume level (S380).

The controller 150 controls the switching unit 131-1 to transfer the audio signal output from the audio processor 125 to the internal speaker 131-3 (S390).

Therefore, the audio signal output from the audio processor 125 is output via the internal speaker 131-3.

The process of controlling an audio output according to the type of an external audio output device connected to the DTV, if one of various external speakers and headphones is selectively connected to the single common audio output terminal 131-5, has been explained in detail with reference to the exemplary embodiment.

The external speaker and the headphone provided in this exemplary embodiment are merely exemplary audio output devices having high output power and low output power, respectively. Even if audio output devices other than the above devices are connected to the common audio output terminal 131-5, the technical concept of the exemplary embodiment may be applied. For example, for high output power external audio devices, the audio output may be set to an appropriate pre-set output level. Alternatively, for low output power external audio devices, the audio output may be set to an output level proportional to the currently set volume level.

In this exemplary embodiment, if an external speaker is connected to the common audio output terminal 131-5, the output level of an audio signal is adjusted to the maximum level, but this is merely exemplary for convenience of description. It is possible to adjust the output level of an audio signal to a relatively high level, if not to the maximum level only.

The DTV provided in this exemplary embodiment is merely an exemplary digital device to which the technical concept may be applied. The technical concept of the exemplary embodiment may also be applied to other digital devices besides the DTV.

As described above, according to the exemplary embodiments, an audio signal may be transferred to various types of external audio output devices through a single audio output terminal. Therefore, the external audio output device is more conveniently connected and thus a user's convenience may be enhanced. Furthermore, more than one external audio output device may be connected to the audio output terminal at a time. In this case, a user may select between the various connected external audio output devices using the GUI, and the controller may control the output level of the audio output according to the above processes.

According to the exemplary embodiments, an output level of an audio signal is adjusted to be proper for the type of audio output device connected to the audio output terminal. Therefore, the audio output device outputs audio having a proper level.

The foregoing exemplary embodiments and advantages are merely exemplary and are not to be construed as limiting. The present teaching can be readily applied to other types of apparatuses. Also, the description of the exemplary embodiments is intended to be illustrative, and not to limit the scope of the claims, and many alternatives, modifications, and variations will be apparent to those skilled in the art.

## Claims

1. A digital device comprising:
an audio processor which performs signal processing on an audio signal;
an audio output terminal to which an audio output device is connected, and which transfers the audio signal processed by the audio processor to the audio output device connected to the audio output terminal, wherein the audio output device is separate from the digital device; and
a controller which determines a type of the audio output device connected to the audio output terminal, controls the audio processor to adjust an output level of the audio signal to a first level if the controller determines that the audio output device is a first type of audio output device, and controls the audio processor to adjust the output level of the audio signal to a second level if the controller determines that the audio output device is a second type of audio output device.

2. The digital device as claimed in claim 1, further comprising:
a video processor which performs signal processing on a video signal; and
a display which displays the video signal processed by the video processor.

3. The digital device as claimed in claim 2, wherein the second level is equal to or less than the first level.

4. The digital device as claimed in claim 3, wherein the second level is proportional to a currently set volume level of the audio signal.

5. The digital device as claimed in claim 3 or 4, wherein the first level is the maximum output level of the audio signal.

6. The digital device as claimed in one of claims 3 to 5, wherein the first type of audio output device is an audio output device having a first output power, and the second type of audio output device is an audio output device having a second output power which is lower than the first output power.

7. The digital device as claimed in one of claims 2 to 6, wherein the controller determines the type of the audio output device connected to the audio output terminal based on an input made on a graphical user interface (GUI) displayed on the display.

8. The digital device as claimed in claim 7, wherein the controller controls the GUI to be displayed on the display if the controller determines that the audio output device is connected to the audio output terminal.

9. The digital device as claimed in one of claims 2 to 8, further comprising:
an internal speaker which is connected to the audio processor and outputs the audio signal processed by the audio processor; and
a switching unit which causes the audio signal processed by the audio processor to be output to either the internal speaker or the audio output terminal,
wherein the controller controls the switching unit so that the audio signal processed by the audio processor is output to the audio output terminal if the controller determines that the audio output device is connected to the audio output terminal.

10. The digital device as claimed in claim 9, wherein the controller controls the switching unit so that the audio signal processed by the audio processor is output to the internal speaker if the controller determines that the audio output device is not connected to the audio output terminal.

11. The digital device as claimed in one of claims 2 to 10, wherein the first type of audio output device and the second type of audio output device are configured to be connected to a same audio output terminal.

12. The digital device as claimed in one of claims 2 to 11, further comprising:
a broadcast reception unit which receives a broadcast signal from an external source,
wherein the video signal and the audio signal are separated from the broadcast signal.

13. The digital device as claimed in claim 12, further comprising:
a broadcast separation unit which separates the broadcast signal received from the broadcast reception unit into the video signal and the audio signal, and outputs the separated signals to the video processor and the audio processor, respectively.

14. A method for controlling an audio output of a digital device, the method comprising:
determining a type of an audio output device which is connected to an audio output terminal of the digital device and is separate from the digital device;
adjusting an output level of the audio signal to a first level if it is determined that the audio output device is a first type of audio output device;
adjusting the output level of the audio signal to a second level if it is determined that the audio output device is a second type of audio output device; and
transferring the audio signal of which the output level is adjusted to the audio output device connected to the audio output terminal.

15. The method as claimed in claim 14, the method further comprising:
performing signal processing on a video signal; and
displaying the processed video signal on a display of the digital device.
